(19) Europäisches Patentamt
European Patent Office
Office européen des brevets

(11) EP 1 452 920 A2

(12) EUROPEAN PATENT APPLICATION

(43) Date of publication:
01.09.2004 Bulletin 2004/36

(51) Int Cl.⁷: G03F 7/20

(21) Application number: 04075556.3

(22) Date of filing: 20.02.2004

(84) Designated Contracting States:
AT BE BG CH CY CZ DE DK EE ES FI FR GB GR
HU IE IT LI LU MC NL PT RO SE SI SK TR
Designated Extension States:
AL LT LV MK

(30) Priority: 25.02.2003 EP 03075575

(71) Applicant: ASML Netherlands B.V.
5503 LA Veldhoven (NL)

(72) Inventor: van der Sande, Joris Jan
5655 HV Eindhoven (NL)

(74) Representative:
Prins, Adrianus Willem, Mr. Ir. et al
Vereenigde,
Nieuwe Parklaan 97
2587 BN Den Haag (NL)

(54) **Device manufacturing method, device manufactured thereby, computer program for performing the method, lithographic apparatus, and robotics system**

(57)    The invention relates to a device manufacturing method comprising the steps of:

- providing a radiation beam using a radiation system;
- projecting the radiation beam onto a substrate of radiation sensitive material;
- specifying a trajectory comprising a position and/or an orientation as a function of time to be followed by the substrate relative to the radiation beam, wherein the trajectory is a mathematical smooth function up to at least the third order which connects a first state and a second state, wherein both the first state and the second state comprise boundary values for at least the position and/or the orientation and for first and second derivatives of the position and/or orientation.

Furthermore, the invention relates to a lithographic apparatus arranged for performing the method, and a software program arranged for performing the method.
The invention also relates to a robotics system arranged for specifying a trajectory to be followed between two elements of the system.

Fig. 1

**Description**

The present invention relates to a device manufacturing method comprising the steps of

-    providing a radiation beam using a radiation system;
-    projecting the radiation beam onto a substrate of radiation sensitive material;
-    specifying a trajectory comprising a position and/or an orientation as a function of time to be followed by the substrate relative to the radiation beam, wherein the trajectory is a mathematical smooth function up to at least the third order which connects a first state and a second state, wherein both the first state and the second state comprise boundary values for at least the position and/or the orientation and for first and second derivatives of the position and/or the orientation.

The invention also relates to a computer program for specifying the trajectory for the device manufacturing method.

Furthermore, the present invention also relates to a lithographic projection apparatus arranged for applying the method according to the invention.

The invention also relates to a robotics system comprising:

-    a first movable element,
-    a second element,
-    a setpoint generator arranged for specifying a trajectory comprising a position and/or an orientation as a function of time to be followed by the first element relative to the second element, wherein the trajectory is a mathematical smooth function up to at least the third order which connects a first state and a second state, wherein both the first state and the second state comprise boundary values for at least the position and/or the orientation and for first and second derivatives of the position and/or the orientation;
-    a drive unit for moving the first element with respect to the second element according to the specified trajectory.

The said device manufacturing method is known in practice. According to this method the substrate and the radiation beam are moved relative to each other according to the specified trajectory. This can be accomplished by either moving only the substrate or the radiation beam or by moving both the substrate and the radiation beam. However, mostly in practice, the substrate is moved according to the trajectory in the radiation beam which is stationary.

Generally, in lithographic manufacturing methods, a substrate has to be moved from a first state with a certain position, velocity, acceleration and a certain orientation, angular velocity, and angular acceleration to a second state with a certain position, velocity, and acceleration and a certain orientation, angular velocity, and angular acceleration. According to the known method, a trajectory can be specified comprising a position as a function of time having three continuous derivatives. The latter means that the trajectory is smooth up to the third order.

The throughput of the device manufacturing method depends amongst others on the particulars of the specified trajectory to be followed. At this point two conflicting requirements have to be met. On the one hand there is a requirement of specifying a trajectory yielding a maximal throughput of the device. On the other hand there is a requirement to be met relating to limitations of control equipment used for positioning the substrate with sufficient accuracy and stability in the radiation beam. If the latter requirement is not met there is a risk of not obtaining manufactured devices with a sufficient degree of quality. At present, there is no method or lithographic apparatus which balances the conflicting requirements in an appropriate way.

It is an object of the invention to provide a method and an apparatus which provides a systematic way of balancing the said conflicting requirements. For this, the method according to invention is characterized in that the method also comprises the step of

-    specifying the trajectory which provides the shortest connection in time between the first and second state, wherein the first derivative, the second derivative and the third derivative of the trajectory are bound by predetermined values.

In this way a well-defined mathematical problem is formulated yielding one and only one trajectory associated with an optimal throughput of the method while maintaining a sufficient degree of quality of the manufactured devices. Since the said predetermined values relate to the quality of the manufactured devices, the method and apparatus can efficiently and optimally be adapted to for example changing working requirements by adjusting these predetermined values accordingly. The trajectory to be followed can be calculated in real time using straightforward analytical equations. In practice, the boundary values for the second derivatives in the first and second states will often be set at zero, which simplifies the mathematical equations to be solved.

An embodiment of the method according to the invention is characterized in that the trajectory is calculated according to the following steps:

- calculating separate respective sub-trajectories for respective dimensions of the position and/or the orientation, wherein each sub-trajectory is a mathematical smooth function up to at least the third order having the shortest connection time between the first state and the second state in the concerned dimension, wherein the first derivative, the second derivative and the third derivative of each sub-trajectory are bound by predetermined values specified for that sub-trajectory;
- selecting the sub-trajectory out of the calculated sub-trajectories which has the largest connection time;
- prolonging the respective non-selected sub-trajectories to the connection time of the selected sub-trajectory while meeting the requirements of the respective predetermined values for the respective sub-trajectories;
- generating the said trajectory by combining the selected sub-trajectory and the prolonged sub-trajectories.

In an example, wherein the trajectory comprises a position and an orientation, the trajectory can be 6-dimensional (three dimensions or degrees of freedom for position and three for orientation). In this case for each dimension a sub-trajectory with the shortest connection time will be calculated (total of six sub-trajectories). Then, the sub-trajectory with has the largest connection time is selected and the other sub-trajectories are prolonged to this connection time. Finally, combining the six sub-trajectories (the selected and 5 prolonged sub-trajectories) yields the 6-dimensional trajectory.

Each sub-trajectory is bound by (individual) predetermined values. For the respective dimensions of position (corresponding to the respective sub-trajectories) respective boundary values for the velocity (first derivative of position), acceleration (second derivative of position) and jerk (third derivative of position) can be specified with the predetermined values.

The computer program according to the invention is arranged for specifying the trajectory to be used in the method and apparatus of the invention.

The lithography apparatus and the robotics system according to the invention are characterized in that the setpoint generator is arranged for specifying the trajectory which provides the shortest connection in time between the first and second state, wherein the first derivative, the second derivative and the third derivative of the trajectory are bound by predetermined values.

Hereafter, more detailed method steps are defined for calculating sub-trajectories and for calculating prolonged sub-trajectories. Furthermore, limitations on prolonging sub-trajectories in the case of a so-called gap-crossing-move are described. With respect to these and other aspects, the figure description gives more detailed information for providing a better understanding of the invention.

Now, the invention is explained in more detail in the figure description with reference to the accompanying drawing, wherein:

Fig. 1 schematically shows a lithography apparatus;
Fig. 2A and 2B show an acceleration profile;
Fig. 3A and 3B shows eight specific acceleration profiles;
Fig. 4 shows a position-velocity diagram for a gap-crossing-move;
Fig. 5A shows two respective acceleration profiles corresponding to a sub-trajectory in a x-dimension and a prolonged sub-trajectory in the x-dimension;
Fig. 5B shows an acceleration profile corresponding to a sub-trajectory with a gap-crossing-move and two acceleration profiles corresponding to prolonged sub-trajectories;
Fig. 5C shows a trajectory depicted in the x-y plane.

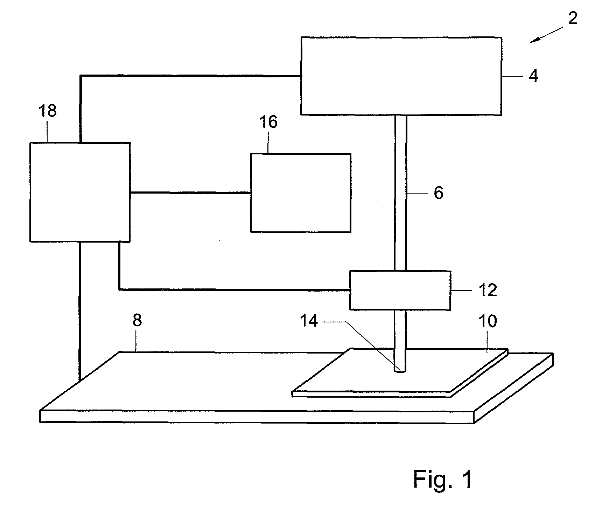

Figure 1 schematically shows a lithographic projection apparatus 2 comprising a radiation system 4 for providing a radiation beam 6. The apparatus 2 also comprises a substrate table 8 for holding a substrate 10 of radiation sensitive material, a projection system 12 for projecting the radiation beam 6 onto a target portion 14 of the substrate 10.

The apparatus 2 comprises a setpoint generator 16 for specifying a trajectory comprising a position and/or an orientation as a function of time to be followed by the substrate 10 relative to the radiation beam 6. The specified trajectory is a mathematical smooth function up to at least the third order, such that it has mathematically well-defined derivations of the position and/or orientation as a function of time up to the third order. The first derivative of the position is the velocity, the second derivative is the acceleration and the third derivative is the jerk. The first derivative of the orientation is the angular velocity, the second derivative is the angular acceleration and the third derivative is the angular jerk. The specified trajectory connects a first state with a second state. The first state can be a begin state (defining a starting position) and the second state can be an end state of the (sub)trajectory. Both the first state and the second state comprise boundary values for the position and/or orientation as well as for first and second derivatives thereof.

The lithography apparatus also comprises a control unit 18 for moving the substrate table 8 with the substrate, the projection system 12 and/or the radiation beam according to the specified trajectory. (Although not mentioned in this specific example, the lithographic apparatus can comprise a reticle/mask which then preferably also can be moved by means of the control unit 18). Preferably the control unit 18 is provided with servo motors for moving the substrate table 8 relative to the radiation beam 6. Furthermore, the control unit in this example is provided with measurement sensors for measuring the state (the state comprising for example a position, velocity, acceleration and/or jerk, and preferably also an orientation, angular velocity, angular acceleration and/or an angular jerk) of the substrate table 8. Mostly, in practice, the measurement sensors only measure the position and the orientation (angular position), wherein the derivatives are calculated from these measured values.

According to the invention the setpoint generator 16 is arranged for specifying the trajectory which is the shortest connection in time between the first and second state, wherein the velocity, the angular velocity, the acceleration, the angular acceleration, the jerk and/or the angular jerk of the trajectory are bound by predetermined values. The predetermined values are specified in accordance with the performance figures of the control unit 18 (in particular of the servos of the control unit 18), such that the specified trajectory can be followed with sufficient accuracy. These predetermined values can for example comprise a maximum absolute velocity, a maximum absolute acceleration and a maximum absolute jerk (and in an analogous way maximum values for angular velocity and derivatives).

The trajectory preferably is calculated according to the following steps:

- calculating separate respective sub-trajectories for respective dimensions of the position and/or the orientation, wherein each sub-trajectory is a mathematical smooth function up to at least the third order having the shortest connection time between the first state and the second state in the concerned dimension, wherein the first derivative, the second derivative and the third derivative of each sub-trajectory are bound by predetermined values specified for that sub-trajectory;
- selecting the sub-trajectory out of the calculated sub-trajectories which has the largest connection time;
- prolonging the respective non-selected sub-trajectories to the connection time of the selected sub-trajectory while meeting the requirements of the respective predetermined values for the respective sub-trajectories;
- generating the said trajectory by combining the selected and prolonged sub-trajectories.

The foregoing is elucidated hereafter by means of a non-limiting example for calculating a sub-trajectory which only comprises a position (with derivatives). Hereafter, the following notation is used. The position of a sub-trajectory at the time $t$ is noted as $r$ (or more formally $r(t)$), the velocity as $v$ (or $v(t)$), the acceleration as $a$ (or $a(t)$) and the jerk as $j$ (or $j(t)$). The respective first and second states which are connected by the sub-trajectory are respectively $(r_b, v_b, a_b, j_b)$ and $(r_e, v_e, a_e, j_e)$. In this example, the accelerations $a_b$ and $a_e$ in the first and second states are both zero. The predetermined values for this particular sub-trajectory comprise a maximum absolute velocity $V$, a maximum absolute acceleration $A$ and a maximum absolute jerk $J$.

For achieving a sub-trajectory of a third-order having the shortest connection time between the states the acceleration is changed as fast as possible using the maximum jerk $J$. An example of a trajectory having such an acceleration profile comprising three subsequent time intervals is as follows:

1. Maximum jerk $j= J$ (building up a maximum acceleration in the shortest time possible);
2. Zero jerk $j=0$ (constant acceleration);
3. Minimal jerk $j= -J$ (decreasing the acceleration in the shortest time possible).

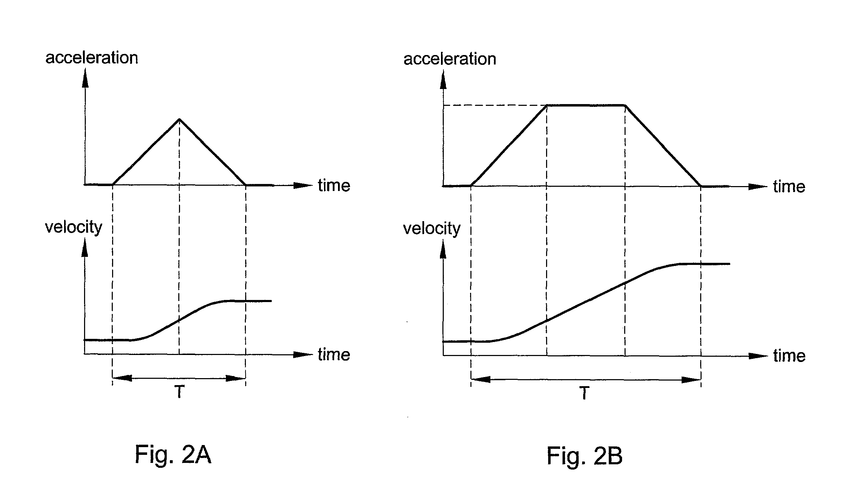

The time required for changing the acceleration from $a=0$ to $a=A$ is $A/J$. Likewise the duration of changing the acceleration from $a=0$ to $a=-A$ with $j=-J$ is $(-A)/(-J)$. For connection times $T>=2A/J$ the acceleration profile must be trapezoid in order not to violate the absolute boundary value $A$ for the acceleration. The corresponding acceleration profile $a$ as a function of time $t$ is given in the upper part of figure 2B, and the corresponding velocity $v$ as function of time $t$ is given in the lower part of figure 2B.

Figure 2A shows an acceleration profile wherein $T<= 2A/J$. The formulas defining the position and velocity of the first state (at the start of the acceleration profile) and second state (at the end of the acceleration profile) of this profile are:

$$r_e = r_b + \int_0^T v(t)\,dt = r_b + v_b T + \tfrac{1}{8} kJT^3 \qquad (1)$$

$$v_e = v_b + \int_0^T a(t)dt = v_b + \tfrac{1}{4}kJT^2 \qquad (2)$$

wherein $a(t)$ is given by:

$$a(t) = \begin{cases} kJt & \text{if } 0 \leq t \leq T/2 \\ kJ(T-t) & \text{if } T/2 \leq t \leq T \end{cases} \qquad (3)$$

and wherein $k=1$ in case of a positive jerk $j$, wherein $k=-1$ in case of a negative jerk $j$, and wherein $T$ is the duration in time of the whole concerning sub-trajectory.

The formulas defining the position and velocity of the first and the second state of the sub-trajectory associated with figure 2B (under the condition $T \geq 2A/J$) are:

$$r_e = r_b + \int_0^T v(t)dt = r_b + v_b T + \tfrac{1}{2}kAT^2 - \frac{kA^2 T}{2J} \qquad (4)$$

$$v_e = v_b + \int_0^T a(t)dt = v_b + kAT - kA^2/J \qquad (5)$$

wherein the function $a(t)$ is given by:

$$a(t) = \begin{cases} kJt & \text{if } 0 \leq t \leq A/J \\ kA & \text{if } A/J \leq t \leq T - A/J \\ kJ(T-t) & \text{if } T - A/J \leq t \leq T \end{cases} \qquad (6)$$

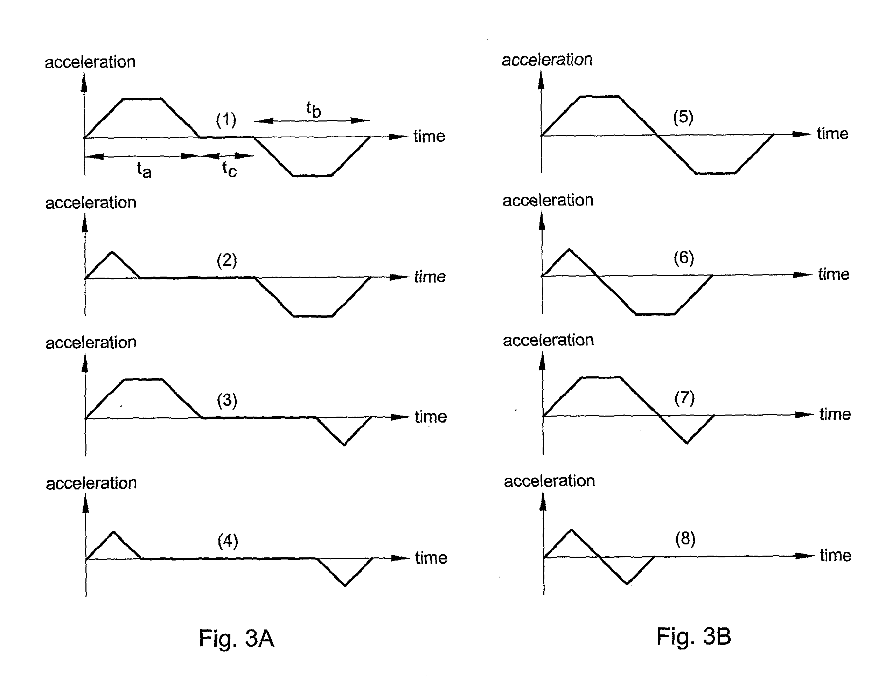

In figures 3A and 3B eight respective basic acceleration profiles corresponding to eight respective basic sub-trajectories are defined. The profiles of figure 3A have a constant velocity part in the middle. The position as a function of time can be calculated in the same way as explained hereinbefore in relation to figures 2A and 2B. On the basis of the profiles of figures 3A and 3B the time optimal sub-trajectory having the shortest connection time can be determined as explained hereafter. The states comprise the boundary values for the sub-trajectory.

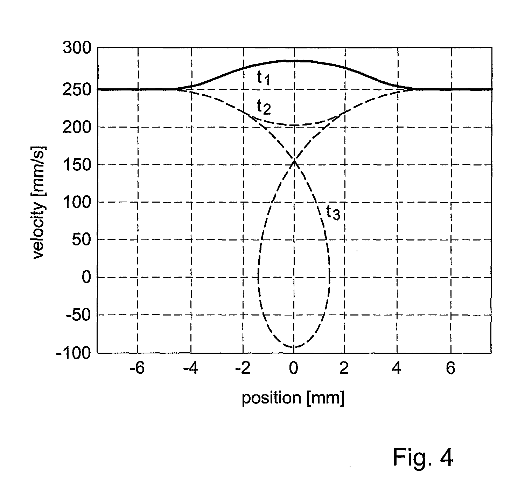

A method step for the detection of a possible gap-crossing-move (which method step can be used in the method according to the invention) is discussed hereafter. The detection of such a gap-crossing-move can be of importance since a gap-crossing-move imposes some limitations on the possibilities of prolonging a sub-trajectory. If a gap-crossing-move is detected then, in general, two intervals with possible connection times for prolonged sub-trajectories are determined. For illustration purposes, figure 4 presents a position-velocity diagram of a gap-crossing move.

A gap-crossing-move is detected if the following formulas are satisfied:

$$v_b > 0 \ \wedge \ v_e > 0 \ \wedge \ r_e > r_b \qquad (7)$$

$$v_b < 0 \ \wedge \ v_e < 0 \ \wedge \ r_{e'} < r_b \qquad (8)$$

$$|r_e - r_b| < \Delta r(v_b) + \Delta r(v_e) \qquad (9)$$

wherein the function $\Delta r(v)$ is given by:

$$\Delta r(v) = \begin{cases} |v|\sqrt{\dfrac{|v|}{J}} & \text{if } |v| \le A^2/J \\[2em] \frac{1}{2}|v|\left(\dfrac{|v|}{A} + \dfrac{A}{J}\right) & \text{if } |v| \ge A^2/J \end{cases} \qquad (10)$$

wherein a gap-crossing-move is detected if

    I. either equation (7) or equation (8) is satisfied, and
    II. equation (9) is satisfied.

The detection of a possible gap-crossing-move is in particular of importance for prolonging a sub-trajectory for which a gap-crossing-move has been detected. In case of a gap-crossing-move there can be two non-overlapping intervals of possible connection times of concerned prolonged sub-trajectories: A first time interval $[t_1, t_2]$ of relatively short connection times, and a second time interval $[t_3,$ infinity) with relatively long connection times. Thus, if a gap-crossing-move has been detected for one of the sub-trajectories, and the duration of this sub-trajectory has to be prolonged such that its duration equals the duration of a sub-trajectory of the same trajectory relating to another dimension (generally the sub-trajectory of the trajectory with the longest duration time), there is a restriction in prolonging possibilities. The sub-trajectory with the gap-crossing move can not be prolonged to a connection in the time interval $[t_2, t_3]$. In the latter case the sub-trajectory must be prolonged to at least connection time $t_3$.

For calculating an optimal sub-trajectory between a first state comprising a position $r_b$, a velocity $v_b$ and zero acceleration and a second state comprising a position $r_e$, a velocity $v_e$ and zero acceleration, wherein the predetermined values are the maximum absolute velocity $V$, maximum absolute acceleration $A$ and maximum absolute jerk $J$, the sub-trajectories associated with the acceleration profiles given in figure 3A are calculated first of all. If a solution is found, then this is the sub-trajectory with the shortest connection time. However, if no solution is found or a gap-crossing move is detected, then a sub-trajectory associated with one of the profiles of figure 3B has to be calculated for obtaining the optimal (shortest connection time) sub-trajectory.

Figure 3A presents four acceleration profiles $a(t)$ as a function of time which are associated with four respective sub-trajectories of the first kind. Each sub-trajectory of the first kind which has a first time interval of duration $t_a$, a subsequent second time interval of duration $t_c$ (wherein the acceleration $a(t)$ is zero), and a subsequent third time interval $t_b$. Figure 3B presents four respective acceleration profiles $a(t)$ as a function of time which are associated with four respective sub-trajectories of the second kind. Each sub-trajectory of the second kind has a first time interval of duration $t_a$ and a subsequent second time interval of duration $t_b$.

The said first step for calculating a sub-trajectory of the first kind can be performed according to the following steps:

-     calculate a time parameter $t_c$ according to:

$$t_c = \frac{r_e - r_b - \Delta r_a - \Delta r_b}{v_i} \qquad (11)$$

wherein $\Delta r_a$ and $\Delta r_b$ are given by:

$$\Delta r_a = \frac{1}{2}(v_b + v_i)t_a \qquad (12)$$

$$\Delta r_b = \frac{1}{2}(v_i + v_e)t_b \qquad (13)$$

wherein $v_i$ is defined by:

$$v_i = \begin{cases} -V & \text{if } r_e - r_b < 0 \\ +V & \text{if } r_e - r_b > 0 \end{cases} \qquad (14)$$

wherein $t_a$ and $t_b$ are given by:

$$t_a = \begin{cases} 2\sqrt{\dfrac{|v_i - v_b|}{J}} & \text{if } |v_i - v_b| \leq A^2/J \\[2ex] \dfrac{|v_i - v_b|}{A} + \dfrac{A}{J} & \text{if } |v_i - v_b| \geq A^2/J \end{cases} \qquad (15)$$

$$t_b = \begin{cases} 2\sqrt{\dfrac{|v_e - v_i|}{J}} & \text{if } |v_e - v_i| \leq A^2/J \\[2ex] \dfrac{|v_e - v_i|}{A} + \dfrac{A}{J} & \text{if } |v_e - v_i| \geq A^2/J \end{cases} \qquad (16)$$

- wherein, if $t_c$ is greater than zero, then a sub-trajectory of the first kind (Fig. 3A) is calculated which comprises three subsequent parts, wherein in the first part a maximum velocity is build up in the shortest time possible within the limitations of the pre-determined values, wherein in the second part, which has a duration of $t_c$, the velocity is constant and equals $v_b$ plus the velocity built up in the first part, and wherein in the third part the velocity is decreased to the velocity $v_e$ in the shortest time possible within the limitations of the predetermined values;
- wherein, if $t_c$ is less than or equal to zero, then a sub-trajectory of a second kind (Fig. 3B) is calculated which comprises two subsequent parts, wherein in the first part a velocity is build up in the shortest time possible within the limitations of the predetermined values, and wherein in the second part the velocity is decreased to the velocity $v_e$ in the shortest time possible within the limitations of the predetermined values.

In the second step, which will be performed if $t_c < 0$ or if a gap-crossing-move has been detected, the calculation of the sub-trajectory of the second kind comprises calculating four respective acceleration profiles associated with four possible sub-trajectories, wherein:

- the first profile type is associated with the first possible sub-trajectory with a connection time $T$ which follows from the quadratic expression:

$$\left\{ \tfrac{1}{2}kA \right\}T^2 + \left\{ (v_e + v_b) - \frac{A^2}{kJ} \right\}T + \left\{ -2(r_e - r_b) - \frac{(v_e - v_b)^2}{2kA} \right\} = 0 \quad (17)$$

wherein the quadratic expression is solved for $k = 1$ and $k = -1$, and wherein the time duration of the first part $t_a$ and the time duration of the second part $t_b$ follow from:

$$t_a = \frac{1}{2}T + \frac{v_e - v_b}{2kA} \qquad (18)$$

$$t_b = \frac{1}{2}T - \frac{v_e - v_b}{2kA} \qquad (19)$$

wherein (17) might yield more than one mathematical solution, wherein the mathematical solutions defining the first profile type satisfy:

$$t_a \geq 2A/J \qquad (20)$$

$$t_b \geq 2A/J \tag{21}$$

$$|v_i| \leq V, \tag{22}$$

wherein for the first profile type $v_i$ is given by:

$$v_i = \frac{1}{2}(v_b + v_e) - \frac{A^2}{KJ} + \frac{1}{2}\, kAT \tag{23}$$

- the second profile type is associated with the second possible sub-trajectory with a time duration $t_a$ of the first part which follows from the quartic expression:

$$\left\{\frac{kJ^2}{32A}\right\}t_a^4 + \left\{\frac{kJ}{8}\right\}t_a^3 + \left\{\frac{v_b J}{4A} + \frac{kA}{8}\right\}t_a^2 + \left\{v_b\right\}t_a + \left\{\frac{(v_e + v_b)A}{2J} - \frac{v_e^2 - v_b^2}{2kA} - (r_e - r_b)\right\} = 0,$$
$$\tag{24}$$

wherein:

$$k = \begin{cases} -1 & \text{if } v_e > v_b \\ +1 & \text{if } v_e < v_b \end{cases}, \tag{25}$$

and wherein the time duration $t_b$ of the second part and the velocity $v_i$ at the transition from the first to the second part follow from:

$$v_i = v_b + \frac{1}{4}\, kJt_a^2 \tag{26}$$

$$t_b = \frac{J}{4A}t_a^2 - \frac{v_e - v_b}{kA} + \frac{A}{J} \tag{27}$$

wherein (24) might yield more than one mathematical solution, wherein the mathematical solutions defining the second profile type satisfy:

$$0 \leq t_a \leq 2A/J \tag{28}$$

$$t_b \geq 2A/J \tag{29}$$

$$|v_i| \leq V \tag{30}$$

and wherein the connection time $T$ of the second possible sub-trajectory follows from $T = t_a + t_b$;

- the third profile type is associated with the third sub-trajectory with a time duration $t_b$ of the second part which follows from the quartic expression:

$$\left[\frac{kJ^2}{32A}\right]t_b^4+\left[\frac{kJ}{8}\right]t_b^3+\left[\frac{v_eJ}{4A}+\frac{kA}{8}\right]t_b^2+\left[v_e\right]t_b+\left[\frac{(v_e+v_b)A}{2J}+\frac{v_e^2-v_b^2}{2kA}-(r_e-r_b)\right]=0,$$

$$(31)$$

wherein:

$$k=\begin{cases}-1 & \text{if } v_e < v_b \\ +1 & \text{if } v_e > v_b\end{cases}, \qquad (32)$$

and wherein the time duration $t_a$ of the first part and the velocity $v_i$ at the transition from the first to the second part follow from:

$$v_i = v_e + \frac{1}{4}kJt_b^2 \qquad (33)$$

$$t_a = \frac{J}{4A}t_b^2 + \frac{v_e - v_b}{kA} + \frac{A}{J} \qquad (34)$$

wherein (31) might yield more than one mathematical solution, wherein the mathematical solutions defining the third profile type satisfy:

$$t_a \geq 2A/J \qquad (35)$$

$$0 \leq t_b \leq 2A/J \qquad (36)$$

$$|v_i| \leq V \qquad (37)$$

and wherein the connection time $T$ of the third possible sub-trajectory follows from $T = t_a + t_b$;

- the fourth profile type is associated with the fourth possible sub-trajectory with a time duration T which follows from the quartic expression:

$$\left[\frac{kJ}{16}\right]T^4+\left[v_e+v_b\right]T^2+\left[-2(r_e-r_b)\right]T+\left[-\frac{(v_e-v_b)^2}{kJ}\right]=0 \qquad (38)$$

wherein the quartic expression is solved for $k=1$ and $k=-1$, and wherein the time duration $t_a$ of the first part and the time duration $t_b$ of the second part and the velocity $v_i$ at the transition from the first to the second part follow from:

$$t_a = \frac{1}{2}T + 2\frac{v_e - v_b}{kJT} \qquad (39)$$

$$t_b = \frac{1}{2}T - 2\frac{v_e - v_b}{kJT} \qquad (40)$$

$$v_i = v_b + \frac{1}{4} kJt_a^2 , \tag{41}$$

wherein (38) might yield more than one mathematical solution, wherein the mathematical solution defining the fourth profile type satisfies:

$$0 \le t_a \le 2A/J \tag{42}$$

$$0 \le t_b \le 2A/J \tag{43}$$

$$|v_i| \le V \tag{44}$$

After performing the calculation of the possible sub-trajectories, the sub-trajectory having the shortest connection time is selected. This selected sub-trajectory is a sub-trajectory of the second kind.

In the case wherein a gap-crossing-move is detected the respective solutions resulting from the respective four groups of equations:

first group of equations (17-23);        (45.I)
second group of equations (24-30);        (45.II)
third group of equations (31-37);        (45.III)
fourth group of equations (38-44)        (45.IV)

are gathered. Next, from these solutions, a selection based on the criterion that $v_b$ and $v_i$ have the same sign is made. From the selection of solutions the corresponding sub-trajectory with the shortest connection time is established and the shortest connection time is defined as $t_1$. Also, from the selection of solutions, the corresponding sub-trajectory with the longest connection time is established and defined as $t_2$. The shortest connection time $t_1$ and the longest connection time $t_2$ define a first connection time interval $[t_1, t_2]$ comprising possible connection times according to which the original sub-trajectory under concern can be prolonged. (It is mentioned that in principle $t_1$ can be equal to $t_2$ in specific examples). Furthermore, in an analogous way, a selection of solutions, for which $v_b$ and $v_i$ have opposite signs, out of the respective solutions resulting from the respective groups of equations, is made. Hereafter, from the corresponding sub-trajectories, the sub-trajectory with the shortest connection time $t_3$ is of importance since the connection time $t_3$ defines a lower limit of a second connection time interval $[t_3, \infty)$ comprising possible connection times according to which the original sub-trajectory can be prolonged.

In an advanced embodiment the setpoint generator is arranged for prolonging the concerned sub-trajectories to the selected sub-trajectory with the largest connection time. If the velocity $v_b$ or the velocity $v_e$ (thus the velocity in the first or second states) is zero then prolonging the concerned sub-trajectory can simply be effected by inserting a connected time interval wherein the velocity is zero. Furthermore, the step for calculating a prolonged sub-trajectory can be based on setting the maximum absolute acceleration A and/or the maximum jerk $J$ of the predetermined values to a lower value. Furthermore, it is also possible to prolong a sub-trajectory by lowering the velocity $v_i$, thereby increasing $T$, wherein the connection time $T$ (in this example $T$ is the time duration of the sub-trajectory) for the sub-trajectory is defined by $T = t_a + t_b + t_c$, and wherein $t_a$, $t_b$ and $t_c$ are given by (for the limitations in case of a gap-crossing-move see above):

$$t_a = \begin{cases} 2\sqrt{\dfrac{|v_i - v_b|}{J}} & \text{if } |v_i - v_b| \le A^2/J \\[2mm] \dfrac{|v_i - v_b|}{A} + \dfrac{A}{J} & \text{if } |v_i - v_b| \ge A^2/J \end{cases} \tag{46}$$

$$t_b = \begin{cases} 2\sqrt{\dfrac{|v_e - v_i|}{J}} & \text{if } |v_e - v_i| \le A^2/J \\[3mm] \dfrac{|v_e - v_i|}{A} + \dfrac{A}{J} & \text{if } |v_e - v_i| \ge A^2/J \end{cases} \tag{47}$$

$$t_c = \frac{r_e - r_b - \Delta r_a - \Delta r_b}{v_i} \tag{48}$$

$$\Delta r_a = \frac{1}{2}(v_b + v_i)\, t_a \tag{49}$$

$$\Delta r_b = \frac{1}{2}(v_i + v_e)\, t_b \tag{50}$$

Hereafter, the foregoing is elucidated by means of a non-limiting example:

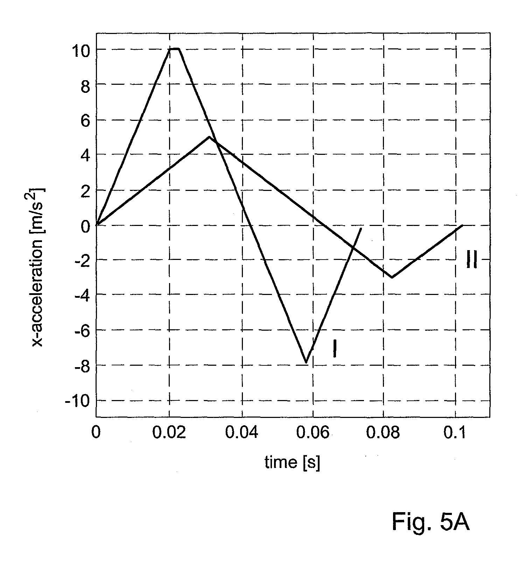

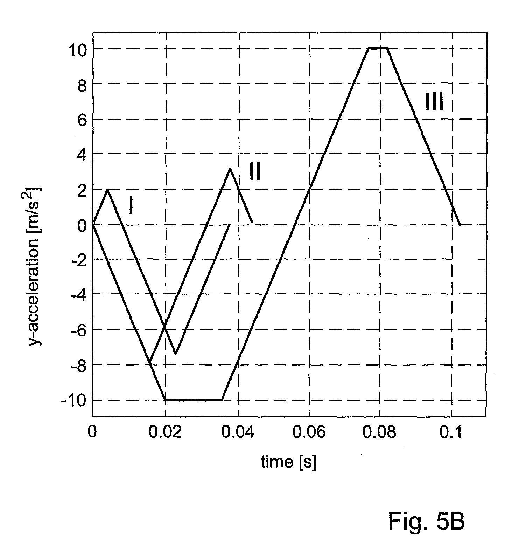

Fig. 5A and Fig. 5B show acceleration profiles of a servo system which comprises a $x$-axis (first dimension) and a $y$-axis (second dimension). The $x$-axis and $y$-axis are, for example, perpendicular with respect to each other. The servo system comprises an object which can be moved by servo motors of the servo system. In particular, the object can be moved independently along the $x$-axis and $y$-axis. For simplicity, in this specific example, both servos have the same characteristics: a maximum absolute velocity $V$ of 0.5 m/s, a maximum absolute acceleration $A$ of 10 m/s$^2$ and a maximum absolute jerk $J$ of 500 m/s$^3$.

In this example it is shown how the trajectory, being mathematically smooth up to the third order, having the shortest connection time between a first state and a second state with boundary values can be found. The first state comprises two positions (in both the first dimension [$x$-axis] and second dimension [$y$-axis]), two velocities, two accelerations and two jerks (thus the velocities and jerks also in the two dimensions). The first state is divided in a first $x$-substate for the first dimension and a first $y$-substate for the second dimension in order to simplify notations. In an analogous way the second state is divided in two respective substates for the respective dimensions. The first $x$-substate is $(r_{bx}, v_{bx}, a_{bx})=(0, 0, 0)$ and the second $x$-substate is $(r_{ex}, v_{ex}, a_{ex})=(0.01, 0.1, 0)$. A $x$-sub-trajectory in the first dimension is calculated between the first x-sub-state (begin of x-sub-trajectory) and the second $x$-substate (end of $x$-sub-trajectory). The first $y$-substate is $(r_{by}, v_{by}, a_{by})=(0, 0.3, 0)$ and the second $y$-substate is $(r_{ey}, v_{ey}, a_{ey})=(0.01, 0.2, 0)$. A $y$-sub-trajectory in the second dimension is calculated between the first y-sub-state (begin of $y$-sub-trajectory) and the second y-substate (end of $y$-sub-trajectory). Finally, the $x$- and $y$-sub-trajectories are combined for generating the trajectory between the first state and the second state. This is explained hereafter in more detail.

A check for a possible gap-crossing-move is made for the x-sub-trajectory in the first dimension. Since for this x-sub-trajectory neither requirement (7) nor (8) is satisfied, there is no gap-crossing move. Subsequently, ax-sub-trajectory of the first kind is tried. Equations (11) to (16) yield a negative duration $t_c$ of -0.051 seconds, which means the time-optimal $x$-sub-trajectory must be of the second kind. Evaluating equations (17) to (22) yields no valid solution. Nor do equations (23) to (29). Evaluating equations (30) to (36) gives one valid solution: $t_b$=0.032 s, $T$=0.074 s. Equations (37) to (39) yield no valid solution. The time-optimal $x$-sub-trajectory (thus with shortest connection time) is the mathematical solution with the lowest $T$. Since only one solution was found ($T$=0.074 s), this must be the time-optimal $x$-sub-trajectory. Since the move in the $x$-dimension is not a gap-crossing move, the time-optimal sub-trajectory can be prolonged by any arbitrary time. Figure 5A shows the acceleration as function of time of this time-optimal sub-trajectory (continuous-line graph indicated with number 1). Also shown is an acceleration profile of a prolonged version of this sub-trajectory (dotted-line graph indicated with number II).

A check for a possible gap-crossing-move is made for the $y$-sub-trajectory in the second dimension. Conditions (7), (9) are satisfied, therefore the move is a gap-crossing move. Next a $y$-sub-trajectory of the first kind is tried. Equations (11) to (16) yield a negative duration $t_c$ of - 0.047 seconds, which means the time-optimal $y$-sub-trajectory must be of the second kind. Evaluating equations (17) to (22) gives one valid solution: $k$=-1, $T$=0.102 s (with velocity $v_i$=0.058 m/s at the transition from the first to the second part of the $y$-sub-trajectory). Evaluating equations (23) to (29) yields no valid solution. Also, equations (30) to (36) yield no valid solution. Equations (37) to (39) yield two valid solutions: $k$=-1, $T$=0.045 s (with $v_i$=0.178 m/s), and $k$=+1, $T$=0.038 s (with $v_i$=0.309 m/s).

The mathematical solution with the lowest $T$ is the fastest y-sub-trajectory possible. Its connection-time of 0.038 seconds is denoted $t_1$. However, since this is a gap-crossing move, this y-sub-trajectory can not be prolonged by any arbitrary time. The mathematical solution with the largest $T$ in which velocity $v_i$ has the same sign as $v_b$ or $v_e$

(i.e. positive), is the *y*-sub-trajectory of which the connection-time will be denoted $t_2$, in this example 0.045 seconds. The *y*-sub-trajectory with connection-time $t_1$ can be prolonged until its connection-time is $t_2$. Further increasing the connection-time of the *y*-sub-trajectory is not possible without coming to a full stop. Only if the object comes to a standstill in the direction of the *y*-axis, backs up a bit and accelerates again, a valid *y*-sub-trajectory with a longer connection-time than $t_2$ can be generated. The mathematical solution with the lowest *T* in which velocity $v_i$ has the opposite sign of $v_b$ or $v_e$, that is, the solution with *T*=0.102 seconds, is the y-sub-trajectory of which the connection-time will be denoted $t_3$, This *y*-sub-trajectory can be prolonged by any arbitrary time. In conclusion, the connection-time *T* of the move in the *y*-dimension must be at least 0.038 seconds (graph of corresponding acceleration profile indicated with number I in Fig. 5B), and may not be between 0.045 and 0.102 seconds. (The acceleration profile corresponding to the *y*-sub-trajectory with connection time *T*=0.045 is indicated with number II in Fig. 5B, and the acceleration profile corresponding to the y-sub-trajectory with connection time *T*=0.102 is indicated with number III in Fig. 5B.)

Now the connection-time of the time-optimal multi-dimensional trajectory must be determined by selecting the fastest connection-time that is possible for all dimensions. The sub-trajectory in the *x*-dimension must be at least 0.074 seconds, the sub-trajectory in the *y*-dimension must be at least 0.038 seconds. Therefore the connection-time of the multi-dimensional trajectory should be at least 0.074 seconds. However, the move in the *y*-dimension can not have a connection-time between 0.045 and 0.102 seconds. Therefore the connection-time of the time-optimal multi-dimensional trajectory must be 0.102 seconds.

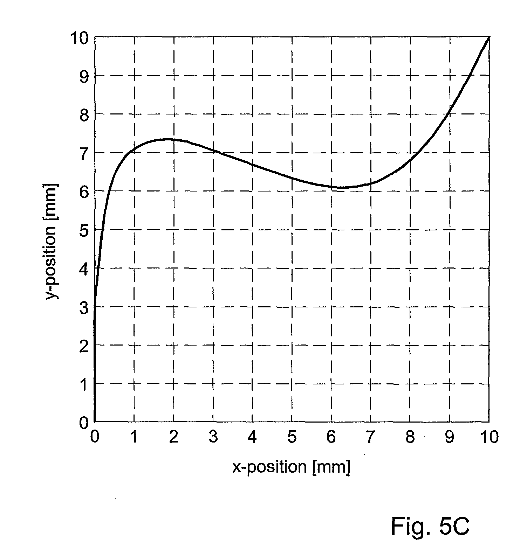

The mathematical solution for a *y*-sub-trajectory with connection-time *T*=0.102 seconds has already been found (that is: in fact its acceleration profile which, together with the first and second *y*-substates, uniquely defines the *y*-sub-trajectory). A *x*-sub-trajectory with connection-time *T*=0.102 seconds must be created by prolonging the mathematical solution with *T*=0.074 seconds. In this example, this is done by lowering the jerk of this *x*-sub-trajectory, see figure 5A, graph with number II. Subsequently, the thus prolonged *x*-sub-trajectory can be combined with the *y*-sub-trajectory (which sub-trajectories now have the same time duration) yielding the desired time-optimal (shortest time duration) mathematically smooth (smooth up till order three) multi-dimensional-trajectory between the first and second states. Figure 5C shows this trajectory in the *x-y* plane.

It is noted that the given examples in the description are only meant for elucidating the invention and do by no means limit the scope of the invention.

**Claims**

**1.** A device manufacturing method comprising the steps of:

- providing a radiation beam using a radiation system;
- projecting the radiation beam onto a substrate of radiation sensitive material;
- specifying a trajectory comprising a position and/or an orientation as a function of time to be followed by the substrate relative to the radiation beam, wherein the trajectory is a mathematical smooth function up to at least the third order which connects a first state and a second state, wherein both the first state and the second state comprise boundary values for at least the position and/or the orientation and for first and second derivatives of the position and/or the orientation,

   **characterized in that**,
   the method also comprises the step of:

- specifying the trajectory which provides the shortest connection in time between the first and second state, wherein the first derivative, the second derivative and the third derivative of the trajectory are bound by predetermined values.

**2.** Method according to claim 1,
   **characterized in that**,
   the boundary values for the second derivatives in the first and second state are zero.

**3.** Method according to one of the preceding claims,
   **characterized in that**,
   the method also comprises the steps of generating the trajectory according to:

- calculating separate respective sub-trajectories for respective dimensions of the position and/or the orientation, wherein each sub-trajectory is a mathematical smooth function up to at least the third order having the shortest connection time between the first state and the second state in the concerned dimension, wherein the first derivative, the second derivative and the third derivative of each sub-trajectory are bound by predetermined values specified for that sub-trajectory;

- selecting the sub-trajectory out of the calculated sub-trajectories which has the largest connection time;
- prolonging the respective non-selected sub-trajectories to the connection time of the selected sub-trajectory while meeting the requirements of the respective predetermined values for the respective sub-trajectories;
- generating the said trajectory by combining the selected sub-trajectory and the prolonged sub-trajectories.

4. Method according to claim 3,
   **characterized in that**,
   the method comprises the step of calculating at least one sub-trajectory between a position $r_b$, velocity $v_b$ and zero acceleration of a first state and a second position $r_e$, velocity $v_e$ and zero acceleration of the second state according to the following steps:

   - calculate a time parameter $t_c$ according to:

$$t_c = \frac{r_e\text{-}r_b\text{-}\Delta r_a\text{-}\Delta r_b}{v_i} \qquad \text{(F1)}$$

   wherein $\Delta r_a$ and $\Delta r_b$ are given by:

$$\Delta r_a = \frac{1}{2}(v_b + v_i)\, t_a \qquad \text{(F2)}$$

$$\Delta r_b = \frac{1}{2}(v_i + v_e)\, t_b \qquad \text{(F3)}$$

   wherein $v_i$ is defined by:

$$v_i = \begin{cases} -V & \text{if } r_e - r_b < 0 \\ +V & \text{if } r_e - r_b > 0 \end{cases} \qquad \text{(F4)}$$

   *wherein V* is a predetermined value defining the maximum absolute velocity, and wherein $t_a$ and $t_b$ are given by:

$$t_a = \begin{cases} 2\sqrt{\dfrac{|v_i - v_b|}{J}} & \text{if } |v_i - v_b| \le A^2/J \\[2mm] \dfrac{|v_i - v_b|}{A} + \dfrac{A}{J} & \text{if } |v_i - v_b| \ge A^2/J \end{cases} \qquad \text{(F5)}$$

$$t_b = \begin{cases} 2\sqrt{\dfrac{|v_e - v_i|}{J}} & \text{if } |v_e - v_i| \le A^2/J \\[2mm] \dfrac{|v_e - v_i|}{A} + \dfrac{A}{J} & \text{if } |v_e - v_i| \ge A^2/J \end{cases} \qquad \text{(F6)}$$

   wherein $A$ is a predetermined value defining the maximum absolute acceleration of the sub-trajectory and wherein $J$ is a predetermined value defining the maximum absolute jerk of the sub-trajectory;

   - wherein, if $t_c$ is greater than zero, then a sub-trajectory of the first kind is calculated which comprises three subsequent parts, wherein in the first part a maximum velocity is build up in the shortest time $t_a$ possible within the limitations of the predetermined values for the sub-trajectory, wherein in the second part, which has a duration of $t_c$, the velocity is constant and equals $v_b$ plus the velocity built up in the first part, and wherein in the third part the velocity is decreased to the velocity $v_e$ in the shortest time $t_b$ possible within the limitations of the predetermined values of the sub-trajectory;

- wherein, if $t_c$ is less than zero, a sub-trajectory of a second kind is calculated which comprises two subsequent parts, wherein in the first part a velocity is build up in the shortest time $t_a$ possible within the limitations of the predetermined values of the sub-trajectory, and wherein in the second part the velocity is decreased to the velocity $V_e$ in the shortest time $t_b$ possible within the limitations of the predetermined values of the sub-trajectory.

5. Method according to claim 4,
   **characterized in that**,
   the method comprises the step of performing a detection of a gap-crossing-move according to:

$$v_b > 0 \wedge v_e > 0 \wedge r_e > r_b \qquad \text{(F7)}$$

$$v_b < 0 \wedge v_e < 0 \wedge r_e < r_b \qquad \text{(F8)}$$

$$|r_e - r_b| < \Delta r(v_b) + \Delta r(v_e) \qquad \text{(F9)}$$

wherein the function $\Delta r(v)$ is given by:

$$\Delta r(v) = \begin{cases} |v|\sqrt{\dfrac{|v|}{J}} & \text{if } |v| \le A^2/J \\[2mm] \tfrac{1}{2}|v|\left(\dfrac{|v|}{A}+\dfrac{A}{J}\right) & \text{if } |v| \ge A^2/J \end{cases} \qquad \text{(F10)}$$

wherein a gap-crossing-move is detected if

 I. either equation (F7) or equation (F8) is satisfied, and
 II. equation (F9) is satisfied.

6. Method according to claim 5,
   **characterized in that**,
   if $t_c < 0$, or if a gap-crossing-move is detected, the calculation of the sub-trajectory of the second kind comprises the step of calculating four respective types of acceleration profiles associated with four possible sub-trajectories and the step of the subsequent selection of the sub-trajectory out of the four possible sub-trajectories which has the shortest connection time,

- wherein the first profile type is associated with the first possible sub-trajectory with a connection time T which follows from the quadratic expression:

$$\left\{\tfrac{1}{2}kA\right\}T^2 + \left\{(v_e + v_b) - \dfrac{A^2}{kJ}\right\}T + \left\{-2(r_e - r_b) - \dfrac{(v_e - v_b)^2}{2kA}\right\} = 0 \quad \text{(F11)}$$

wherein the quadratic expression is solved for $k = 1$ and $k = -1$, and wherein the time duration of the first part $t_a$ and the time duration of the second part $t_b$ follow from:

$$t_a \; \frac{1}{2}T + \frac{v_e\text{-}v_b}{2kA} \tag{F12}$$

$$t_b \; \frac{1}{2}T - \frac{v_e\text{-}v_b}{2kA} \tag{F13}$$

wherein (F11) might yield more than one mathematical solution, wherein the mathematical solutions defining the first profile type satisfy:

$$t_a \geq 2A/J \tag{F14}$$

$$t_b \geq 2A/J \tag{F15}$$

$$|v_i| \leq V, \tag{F16}$$

wherein for the first profile type $v_i$ is given by:

$$v_i = \frac{1}{2}(v_b + v_e) - \frac{A^2}{kJ} + \frac{1}{2}kAT. \tag{F17}$$

- wherein the second profile type is associated with the second possible sub-trajectory with a time duration $t_a$ of the first part which follows from the quartic expression:

$$\left\{\frac{kJ^2}{32A}\right\}t_a^4 + \left\{\frac{kJ}{8}\right\}t_a^3 + \left\{\frac{v_b J}{4A} + \frac{kA}{8}\right\}t_a^2 + \left\{v_b\right\}t_a + \left\{\frac{(v_e + v_b)A}{2J} - \frac{v_e^2 - v_b^2}{2kA} - (r_e - r_b)\right\} = 0 \tag{F18}$$

wherein:

$$k = \begin{cases} -1 & \text{if } v_e > v_b \\ +1 & \text{if } v_e < v_b \end{cases}, \tag{F19}$$

and wherein the time duration $t_b$ of the second part and the velocity $v_i$ at the transition from the first to the second part follow from:

$$v_i = v_b + \frac{1}{4}kJt_a^2 \tag{F20}$$

$$t_b = \frac{J}{4A}t_a^2 - \frac{v_e\text{-}v_b}{kA} + \frac{A}{J} \tag{F21}$$

wherein (F18) might yield more than one mathematical solution, wherein the mathematical solutions defining the second profile type satisfy:

$$0 \leq t_a \leq 2A/J \qquad \text{(F22)}$$

$$t_b \geq 2A/J \qquad \text{(F23)}$$

$$|v_i| \leq V \qquad \text{(F24)}$$

and wherein the connection time $T$ of the second possible sub-trajectory follows from $T = t_a + t_b$;

- wherein the third profile type is associated with the third sub-trajectory with a time duration $t_b$ of the second part which follows from the quartic expression:

$$\left\{ \frac{kJ^2}{32A} \right\} t_b^4 + \left\{ \frac{kJ}{8} \right\} t_b^3 + \left\{ \frac{v_e J}{4A} + \frac{kA}{8} \right\} t_b^2 + \left\{ v_e \right\} t_b + \left\{ \frac{(v_e + v_b)A}{2J} + \frac{v_e^2 - v_b^2}{2kA} - (r_e - r_b) \right\} = 0 ,$$

$$\text{(F25)}$$

wherein:

$$k = \begin{cases} -1 & \text{if } v_e < v_b \\ +1 & \text{if } v_e > v_b \end{cases} , \qquad \text{(F26)}$$

and wherein the time duration $t_a$ of the first part and the velocity $v_i$ at the transition from the first to the second part follow from:

$$v_i = v_e + \frac{1}{4} kJt_b^2 \qquad \text{(F27)}$$

$$t_a = \frac{J}{4A} t_b^2 + \frac{v_e - v_b}{kA} + \frac{A}{J} \qquad \text{(F28)}$$

wherein (F25) might yield more than one mathematical solution, wherein the mathematical solutions defining the third profile type satisfy:

$$t_a \geq 2A/J \qquad \text{((F29)}$$

$$0 \leq t_b \leq 2A/J \qquad \text{(F30)}$$

$$|v_i| \leq V \qquad \text{(F31)}$$

and wherein the connection time $T$ of the third possible sub-trajectory follows from $T = t_a + t_b$;

- wherein the fourth profile type is associated with the fourth possible sub-trajectory with a time duration $T$ which follows from the quartic expression:

$$\left\{\frac{kJ}{16}\right\}T^4 + \left\{v_e + v_b\right\}T^2 + \left\{-2(r_e - r_b)\right\}T + \left\{-\frac{(v_e - v_b)^2}{kJ}\right\} = 0 \quad \text{(F32)}$$

wherein the quartic expression is solved for $k= 1$ and $k= -1$, and wherein the time duration $t_a$ of the first part and the time duration $t_b$ of the second part and the velocity $v_i$ at the transition from the first to the second part follow from:

$$t_a = \frac{1}{2}T + 2\frac{v_e - v_b}{kJT} \quad \text{(F33)}$$

$$t_b = \frac{1}{2}T - 2\frac{v_e - v_b}{kJT} \quad \text{(F34)}$$

$$v_i = v_b + \frac{1}{4}kJt_a^2 \quad \text{(F35)}$$

wherein (F32) might yield more than one mathematical solution, wherein the mathematical solution defining the fourth profile type satisfies:

$$0 \leq t_a \leq 2A/J \quad \text{(F36)}$$

$$0 \leq t_b \leq 2A/J \quad \text{(F37)}$$

$$|v_i| \leq V \quad \text{(F38)}$$

7. Method according to claim 6,
   **characterized in that**,
   if a gap-crossing-move is detected, then, on the basis of the criterion that $v_b$ and $v_i$ have the same sign, a selection from the respective solutions (F11-F17 (F18-F24), (F25-F31) and (F32-F38) is made, wherein the selection of solutions define respectively the shortest connection time $t_1$ and the longest connection time $t_2$, wherein $t_1$ and $t_2$ define a first connection time interval comprising possible connection times according to which the concerning sub-trajectory can be prolonged, and wherein, on the basis that $v_b$ and $v_i$ have opposite signs, also a selection of the respective solutions (F11-F17), (F18-F24), (F25-F31) and (F32-F38) is made, wherein this selection defines a connection time $t_3$ defining a lower limit of a second connection time interval comprising possible connection times according to which the concerning sub-trajectory can be prolonged.

8. Method according to one of the claims 3 - 7,
   **characterized in that**,
   the step for calculating a prolonged sub-trajectory comprises the step of calculating a sub-trajectory with lower predetermined value or values than the corresponding predetermined value or values of the sub-trajectory to be prolonged.

9. Method according to one of the claims 4 - 8,
   **characterized in that**,
   if $v_b$=0 and/or $v_e$=0, the step for calculating a prolonged sub-trajectory comprises the step of inserting into the sub-trajectory to be prolonged a time interval wherein the velocity is zero.

10. Method according to claim 4, or claim 4 and one of the claims 5-9,
    **characterized in that**,
    the step for calculating a prolonged sub-trajectory comprises the step of lowering the velocity $v_i$, thereby increasing $T$, wherein the connection time $T$ for the sub-trajectory is defined by $T= t_a + t_b + t_c$, and wherein $t_a, t_b$ and $t_c$ are

given by:

$$t_a = \begin{cases} 2\sqrt{\dfrac{|v_i - v_b|}{J}} & \text{if } |v_i - v_b| \le A^2/J \\[3mm] \dfrac{|v_i - v_b|}{A} + \dfrac{A}{J} & \text{if } |v_i - v_b| \ge A^2/J \end{cases} \tag{F39}$$

$$t_b = \begin{cases} 2\sqrt{\dfrac{|v_e - v_i|}{J}} & \text{if } |v_e - v_i| \le A^2/J \\[3mm] \dfrac{|v_e - v_i|}{A} + \dfrac{A}{J} & \text{if } |v_e - v_i| \ge A^2/J \end{cases} \tag{F40}$$

$$t_c = \frac{r_e - r_b - \Delta r_a - \Delta r_b}{v_i} \tag{F41}$$

$$\Delta r_a = \frac{1}{2}(v_b + v_i)\, t_a \tag{F42}$$

$$\Delta r_b = \frac{1}{2}(v_i + v_e)\, t_b, \tag{F43}$$

**11.** A lithographic projection apparatus comprising:

- a radiation system for providing a radiation beam;
- a substrate table for holding a substrate of radiation sensitive material;
- a projection system for projecting the radiation beam onto a target portion of the substrate;
- a setpoint generator for specifying a trajectory comprising a position and/or an orientation as a function of time to be followed by the substrate relative to the radiation beam, wherein the trajectory is a mathematical smooth function up to at least the third order which connects a first state and a second state, wherein both the first state and the second state comprise boundary values for at least the position and/or the orientation and for the first and second derivatives of the position and/or the orientation;
- a drive unit for moving the substrate table and/or the projection system according to the specified trajectory,

**characterized in that**,
the setpoint generator is arranged for specifying the trajectory which provides the shortest connection in time between the first and second state, wherein the first derivative, the second derivative and the third derivative of the trajectory are bound by predetermined values.

**12.** A lithography apparatus according to claim 11,
**characterized in that**,
the boundary values for the second derivatives are zero.

**13.** A lithography apparatus according to one of the claims 9-12,
**characterized in that**,
the setpoint generator is arranged for:

- calculating separate respective sub-trajectories for respective dimensions of the position and/or the orientation, wherein each sub-trajectory is a mathematical smooth function up to at least the third order having the shortest connection time between the first state and the second state in the concerned dimension, wherein the first derivative, the second derivative and the third derivative of each sub-trajectory are bound by predetermined values specified for that sub-trajectory;

- selecting the sub-trajectory out of the calculated sub-trajectories which has the largest connection time;
- prolonging the respective non-selected sub-trajectories to the connection time of the selected sub-trajectory while meeting the requirements of the respective predetermined values for the respective sub-trajectories;
- generating the said trajectory by combining the selected sub-trajectory and the prolonged sub-trajectories.

**14.** A lithography apparatus according to one of the claims 11-13,
   **characterized in that**,
   the lithography apparatus is arranged for applying the method according to one of the claims 4-10.

**15.** A software program which is arranged for carrying out the method according to one of the claims 1-10.

**16.** A robotics system comprising:

- a first movable element,
- a second element,
- a setpoint generator arranged for specifying a trajectory comprising a position and/or an orientation as a function of time to be followed by the first element relative to the second element, wherein the trajectory is a mathematical smooth function up to at least the third order which connects a first state and a second state, wherein both the first state and the second state comprise boundary values for at least the position and/or the orientation and for first and second derivatives of the position and/or the orientation;
- a drive unit for moving the first element with respect to the second element according to the specified trajectory,

   **characterized in that**,
   the setpoint generator is arranged for specifying the trajectory which is the shortest connection in time between the first and second state, wherein the first derivative, the second derivative and the third derivative of the trajectory are bound by predetermined values.

**17.** A robotics system according to claim 16,
   **characterized in that**,
   the boundary values for the second derivatives in the first and second state are zero.

**18.** A robotics system according to one of the claims 16-17,
   **characterized in that**,
   the setpoint generator is arranged for:

- calculating separate respective sub-trajectories for respective dimensions of the position and/or the orientation, wherein each sub-trajectory is a mathematical smooth function up to at least the third order having the shortest connection time between the concerned dimension of the first state and the second state, wherein the first derivative, the second derivative and the third derivative of each sub-trajectory are bound by predetermined values specified for that sub-trajectory;
- selecting the sub-trajectory out of the calculated sub-trajectories which has the largest connection time;
- prolonging the respective non-selected sub-trajectories to the connection time of the selected sub-trajectory while meeting the requirements of the respective predetermined values for the respective sub-trajectories;
- generating the said trajectory by combining the selected sub-trajectory and the prolonged sub-trajectories.

Fig. 1

Fig. 2B

Fig. 2A

Fig. 3A

Fig. 3B

Fig. 4

Fig. 5A

Fig. 5B

Fig. 5C